# EUROPEAN PATENT APPLICATION

(11) **EP 1 424 740 A2**
(43) Date of publication of application: **02.06.2004**
(21) Application number: 03026885.8
(22) Date of filing: 24.11.2003
(51) Int. Cl.: H01L 51/40, H01L 51/20

(54) **Method of manufacturing organic electroluminescence device**

(30) Priority: 26.11.2002 JP 2002342607
(71) Applicant: SONY CORPORATION, Tokyo (JP)
(72) Inventor: Nishiguchi, Masao, Shinagawa-ku Tokyo (JP); Nishimura, Teiichiro, Shinagawa-ku Tokyo (JP)
(74) Representative: Müller - Hoffmann & Partner

(57) **Abstract**

In a wet-type coating apparatus, a gravure roll tapered at both end portions thereof is provided. In this case, the tapered portions are located beneath non-pixel-forming areas present on both sides of an effective pixel forming area of a silicone blanket. With this arrangement, a coating liquid is supplied and applied to the surface of the silicone blanket from the lower side thereof while the film width of a contacted liquid portion held between the effective pixel forming area and the surface of the gravure roll is kept uniform along the direction of the rotational axis of the silicone blanket. By this coating method, the nonuniformity of film width of the contacted liquid portion and the like are absorbed by the tapered portions corresponding to the non-pixel-forming areas.

## Description

### BACKGROUND OF THE INVENTION

The present invention relates to a method of manufacturing an electroluminescence device suitable for use as, for example, a self-light-emitting type thin flat panel display. More particularly, the invention relates to a method of supplying a coating liquid for forming a light emission layer to a surface of a silicone blanket, in the case of manufacturing an electroluminescence device by supplying'the coating liquid to the surface of the silicone blanket to form a coating film, patterning the coating film, and then transferring the patterned film onto a substrate.

Recently, attention has been focused on electroluminescence displays (ELDs) as a lightweight thin flat panel display. The ELDs are classified into organic ELDs and inorganic ELDs. Especially, the organic ELDs are composed of organic electroluminescence devices using an organic compound as a light-emitting material and have lower power consumption as compared with a conventional liquid crystal display. In addition, the organic ELDs have enough response to a high speed video signal having high definition and are a self luminous type. Therefore, the organic ELDs promise realization of flat panel displays free of angle-of-visibility dependence.

Meanwhile, as a method of manufacturing an organic EL display (OELD) using a polymeric organic EL material, methods based on a spin coating system have frequently been used. However, this system is disadvantageous in that the coating efficiency is as low as about 10% and that the coating film thickness in corner areas of a substrate would be too large.

Besides, there has been proposed a method in which each of organic light emission layers for red and green colors, for example, is formed by an ink jet system of jetting an arbitrary amount of a liquid to an arbitrary position (see Japanese Patent Laid-open No. Hei 10-153967). However, the method of forming a film by the ink jet system is basically to compose a thin film of an aggregate of minute droplets, or spots, and it is difficult to obtain a uniform layer thickness by this method. In addition, also in the case of adopting a low-volatility solvent in expectation of leveling after film formation, the leveling performance is limited due to the low solubility of a polymeric EL material in the leveling material.

Further, as a coating system capable of solving the above-mentioned problems encountered in the spin coating system, there has been proposed a method based on a bead coating system (see Japanese Patent Laid-open No. 2001-6875). The method of manufacturing an EL device by this coating system is to manufacture an EL device composed of a substrate, a first electrode formed on the substrate, an EL layer formed on the first electrode, and a second electrode formed on the EL layer. In the method, at least one of the first electrode, the EL layer, and the second electrode is formed by coating. The method is characterized in that the substrate being conveyed is brought into contact with a coating liquid ejected from a belt-like slit extending in a horizontal direction, whereby the coating liquid is adhered in a layer form to the substrate attendant on the movement of the substrate.

In the method based on the bead coating system, however, though a uniform layer thickness can be expected, the system is basically to apply the coating liquid to the whole surface of the substrate and, therefore, requires an after-step for patterning. Accordingly, the method cannot be used directly as a method for manufacturing a full-color polymeric organic EL device (full-color organic electroluminescence device). In addition, in view of the resistance of the polymeric organic EL material to the etching liquid, it is difficult to carry out patterning for three colors of RGB in the after-steps.

Furthermore, as an image forming method for obtaining an image with high definition and high flatness in forming a liquid crystal color filter and printing other functional resins, there has been proposed a method in which a coated surface (coating film) of a functional resin is formed on a silicone blanket, an intaglio plate or a relief printing plate is pressed against the coated surface, the resin in the pressed areas is removed from the silicone blanket, and the resin left on the silicone blanket is transferred onto a body to be printed (see Japanese Patent Laid-open No. 2000-289320). However, this method only takes into consideration the manufacture of a color filter for a liquid crystal display as above-mentioned. In addition, this method is not suitable as a technique for coating the silicone blanket with a coating liquid prepared by dissolving a polymer organic EL material in, for example, an organic solvent.

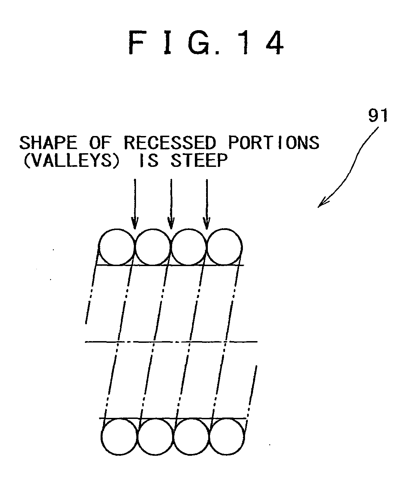

Particularly, in the case where wire bars 91 having a sectional shape as shown in FIG. 14 are used as a coating member, coating streaks due to the mesh of the wire bars and a nonuniformity of layer thickness due to vibration of the apparatus or undulation of the surface of the silicone blanket will occur. Though the coating streaks and the nonuniformity of layer thickness do not matter in the case of the liquid crystal color filter, they may inadvantageously give rise to nonuniformity of light emission in the case of a light-emitting device using a polymeric organic EL material. This is due to the steepness of recessed portions (valley portions) in the surface for holding the coating liquid, as shown in FIG. 14.

### SUMMARY OF THE INVENTION

Accordingly, it is an object of the present invention to provide a method of manufacturing an organic electroluminescence device, which solves the above-mentioned problems in the related art, and particularly to provide a means for applying a coating liquid containing a polymeric organic EL material (for example, a coating liquid prepared by dissolving the EL material in an organic solvent) to a silicone blanket in a uniform layer thickness. In other words, it is an object of the present invention to provide a coating method by which a coating liquid containing a polymeric organic EL material can be applied in a uniform layer thickness to a silicone blanket used in a relief reversal offset printing method in the manufacture of an organic electroluminescence device.

According to the present invention, a coating liquid is supplied, from the lower side, to the surface of a silicone blanket being rotated, and the coating liquid is adhered in a layer form to the silicone blanket under the action of its own surface tension. In order to obtain an extremely small and uniform layer thickness suitable for a light-emitting device using a polymeric organic EL material, it is important to make small the thickness of the contacted liquid portions (a film of the coating liquid) formed upon the contact of the coating liquid with the silicone blanket surface and to minimize the variation of the thickness. For this purpose, according to the present invention, a gravure roll or a slit is used as a member for holding and transporting the coating liquid, namely, as a coating liquid supply head.

According to the present invention, particularly, a coating liquid supply head is used such that the gap between the coating liquid supply surface of the head and the silicone blanket surface is greater at portions corresponding to non-pixel-forming areas than at a portion corresponding to a pixel forming area, and the nonuniformity of liquid width in the contacted liquid portions is absorbed by the portions corresponding to the non-pixel-forming areas, to form a coating film with a uniform and extremely small film thickness on the silicone blanket, thereby providing a polymeric organic EL display device free of nonuniformity of light emission.

In accordance with one aspect of the present invention, there is provided a method of manufacturing an organic electroluminescence device including, between a first electrode and a second electrode, layers having light emission regions patterned on a pixel basis.

At least one of the layers having the light emission regions is formed by forming a coating film composed of a coating liquid containing a constituent material of the layer on a surface of a silicone blanket, then pressing a relief printing plate against the coating film, transferring and removing the coating film at the pressed areas from the silicon blanket onto the relief printing plate, and transferring a pattern composed of the coating film left on the surface of the silicone blanket onto a surface to be provided thereon with the layer, and the coating liquid is supplied and applied to the surface of the silicone blanket from the lower side thereof via a gravure roll provided with a gravure pattern.

By this method, it is possible to stably manufacture an organic electroluminescence device having excellent light emission efficiency and light emission intensity characteristics equivalent to those of a conventional organic electroluminescence in which a light emission layer is formed by a spin coating method.

In the above method of manufacturing an organic electroluminescence device, it is preferable that the gravure roll, which is tapered at both end portions thereof, is provided in such a position that the tapered portions correspond to non-pixel-forming areas on both sides of an effective pixel forming area of the silicone blanket, and the coating liquid is supplied and applied to the surface of the silicone blanket from the lower side thereof.

In this case, it is possible to form a coating film having a higher uniformity of layer thickness on the surface of the silicone blanket and to provide an organic electroluminescence device having more excellent characteristics.

In accordance with another aspect of the present invention, there is provided a method of manufacturing an organic electroluminescence device including, between a first electrode and a second electrode, layers having light emission regions patterned on a pixel basis.

At least one of the layers having the light emission regions is formed by forming a coating film composed of a coating liquid containing a constituent material of the layer on a surface of a silicone blanket, then pressing a relief printing plate against the coating film, transferring and removing the coating film at the pressed portions from the silicone blanket onto the relief printing plate, and transferring a pattern composed of the coating film left on the surface of the silicone blanket onto a surface to be provided thereon with the layer, and the coating liquid is supplied and applied to the surface of the silicone blanket from the lower side thereof via a slit provided in parallel to the rotational axis of the silicone blanket.

By this method, it is possible to stably manufacture an organic electroluminescence device having excellent light emission efficiency and light emission intensity characteristics equivalent to those of a conventional organic electroluminescence in which a light emission layer is formed by a spin coating method.

In the method of manufacturing an organic electroluminescence device, it is preferable that the slit is formed by opposing two flat plates to each other with a spacing therebetween, and totally closing gaps between left and right end portions of the flat plates, the spacing between the surface of the silicone blanket and top faces of the two flat plates is uniform at a slit portion corresponding to an effective pixel forming area of the silicone blanket, whereas the top faces of the two flat plates are slant surfaces with a downward gradient from the central portion side toward end portion sides of the rotational axis of the silicone blanket at slit portions corresponding to non-pixel-forming areas present on both sides of the effective pixel forming area of the silicone blanket, and the coating liquid is supplied and applied to the surface of the silicone blanket from the lower side thereof via the slit.

In addition, in the method of manufacturing an organic electroluminescence device, it is preferable that the slit is formed by opposing two flat plates to each other with a spacing therebetween, opening upper half portions of gaps between left and right end portions of the flat plates, and closing lower half portions of the gaps, and the coating liquid is supplied and applied to the surface of the silicone blanket from the lower side thereof via the slit.

In the last-mentioned two cases, it is possible to form a coating film having a higher uniformity of layer thickness on the surface of the silicone blanket, and to provide an organic electroluminescence device having more excellent characteristics.

In the methods of manufacturing an organic electroluminescence device according to the present invention (according to the one and another aspects of the present invention described above), examples of the "layers having light emission regions" include the followings, of which at least one is formed by the above methods:
(a) A hole transport layer and a light emission layer (Two-layer type organic electroluminescence device)
(b) A hole transport layer, a light emission layer, and an electron transport layer (Three-layer type organic electroluminescence device)
(c) A hole injection layer, a hole transport layer, a light emission layer, an electron transport layer, and an electron injection layer (Five-layer type organic electroluminescence device)

### BRIEF DESCRIPTION OF THE DRAWINGS

These and other objects of the invention will be seen by reference to the description, taken in connection with the accompanying drawing in which:
FIG. 1 pertains to a first embodiment of the present invention, and is a front sectional view of a wet-type coating apparatus including a gravure roll, used for the method of manufacturing an organic electroluminescence device;
FIG. 2A is a front view showing an essential structure of the wet-type coating apparatus of FIG. 1, and FIG. 2B is a right side view thereof;
FIG. 3 is a general vertical sectional view of a part of the gravure roll constituting the wet-type coating apparatus of FIG. 1;
FIG. 4 illustrates schematically the nonuniformity of layer thickness in a coating film in an effective pixel area, formed on the surface of a silicone blanket by a wet-type coating apparatus including a cylindrical gravure roll having a uniform diameter over its whole length;
FIG. 5 illustrates the coating condition in the effective pixel area, upon coating the surface of a silicone blanket by the coating apparatus of FIG. 1;
FIG. 6 is a general sectional view showing one example of an organic electroluminescence device obtained by the manufacturing method according to the first embodiment (or a second embodiment) of the present invention;
FIGS. 7A and 7B pertain to the organic electroluminescence device of FIG. 6, in which FIG. 7A is a plan view of one example of a pattern of pixel electrode portions, and FIG. 7B is a sectional view taken along line A-A thereof;
FIGS. 8A, 8B, and 8C pertain to a process of manufacturing the organic electroluminescence device of FIG. 6 and are sectional views for illustrating the steps of forming an anode on a glass substrate and a hole transport layer on the anode in a laminated form;
FIGS. 9A, 9B, and 9C pertain to the process of manufacturing the organic electroluminescence device of FIG. 6 and are sectional views for illustrating the steps (relief reversal offset printing step) of forming an electron-transporting light emission layer in a predetermined pattern on the hole transport layer on the glass substrate after the steps of FIGS. 8A to 8C;
FIGS. 10A, 10B, and 10C pertain to the second embodiment of the present invention in which FIG. 10A is a front view of a wet-type coating apparatus including a slit, for use in the method of manufacturing an organic electroluminescence device, FIG. 10B is a right side view showing an essential structure thereof, and FIG. 10C is a perspective view of the slit;
FIG. 11 is a perspective view showing another example of the slit constituting the wet-type coating apparatus according to the second embodiment of the present invention;
FIG. 12 is a general sectional view showing another example of the organic electroluminescence device obtained by the manufacturing method according to the first embodiment (or the second embodiment) of the present invention;
FIG. 13 illustrates schematically the laminate structure of the organic electroluminescence device manufactured in the embodiments of the present invention; and
FIG. 14 pertains to one example of a conventional wet-type coating apparatus and is a general sectional view of wire bars constituting the wet-type coating apparatus.

### DETAILED DESCRIPTION OF THE PREFERRED EMBODIMENTS

Now, embodiments of the present invention will be described below, referring to the drawings.

### First Embodiment

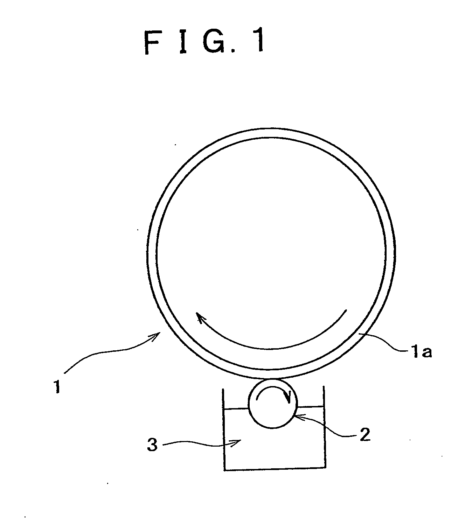

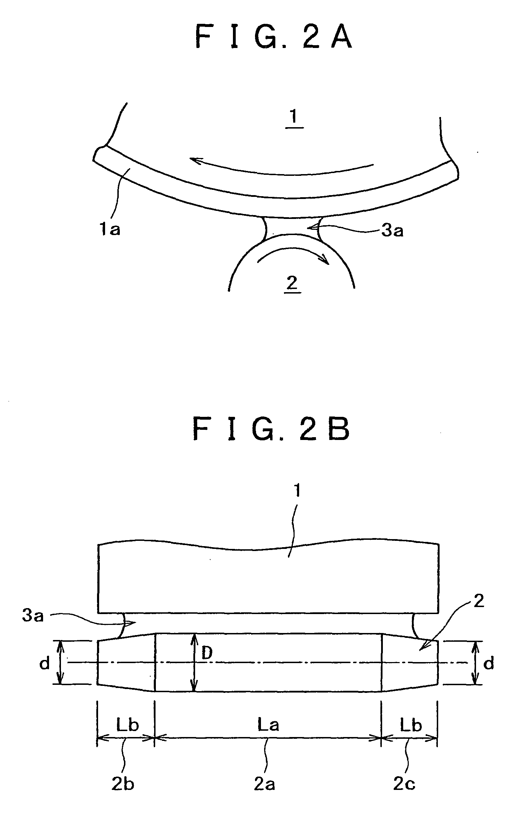

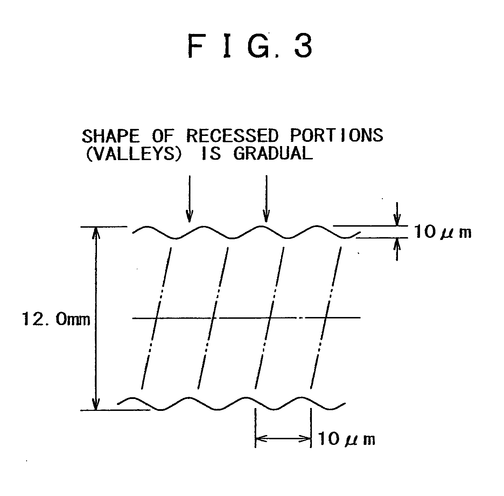

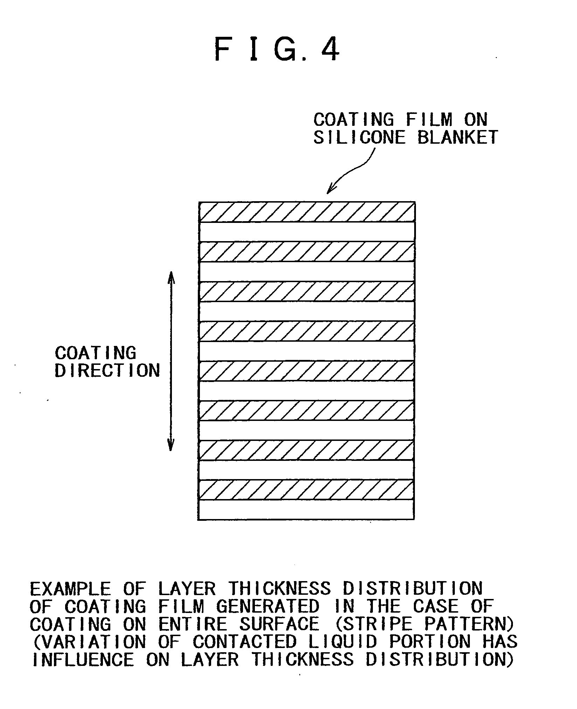

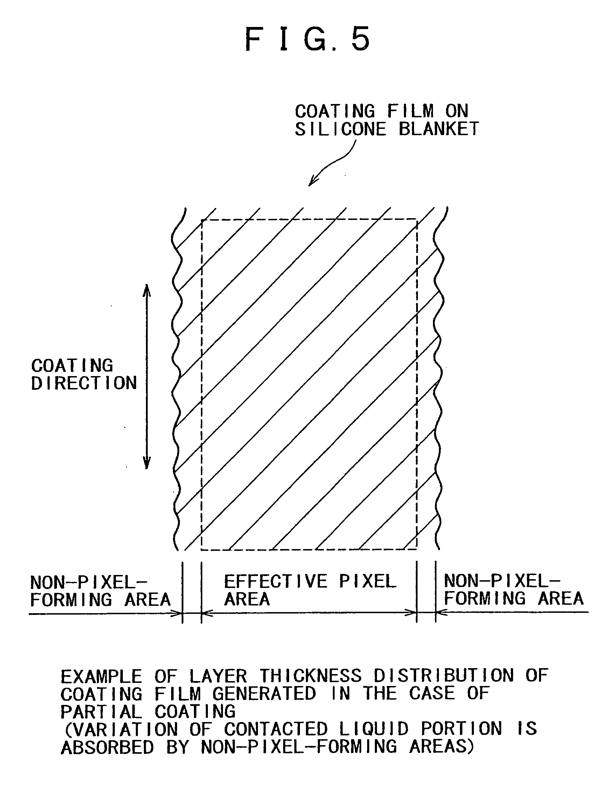

FIG. 1 is a front sectional view of a wet-type coating apparatus including a gravure roll, used for the method of manufacturing an organic electroluminescence device; FIG. 2A is a front view showing an essential structure of the wet-type coating apparatus of FIG. 1, and FIG. 2B is a right side view thereof; FIG. 3 is a general vertical sectional view of a part of the gravure roll constituting the wet-type coating apparatus of FIG. 1; FIG. 4 illustrates schematically the nonuniformity of layer thickness in a coating film in an effective pixel area, formed on the surface of a silicone blanket by a wet-type coating apparatus including a cylindrical gravure roll having a uniform diameter over its whole length; and FIG. 5 illustrates the coating condition in an effective pixel area, upon coating the surface of a silicone blanket by the coating apparatus of FIG. 1.

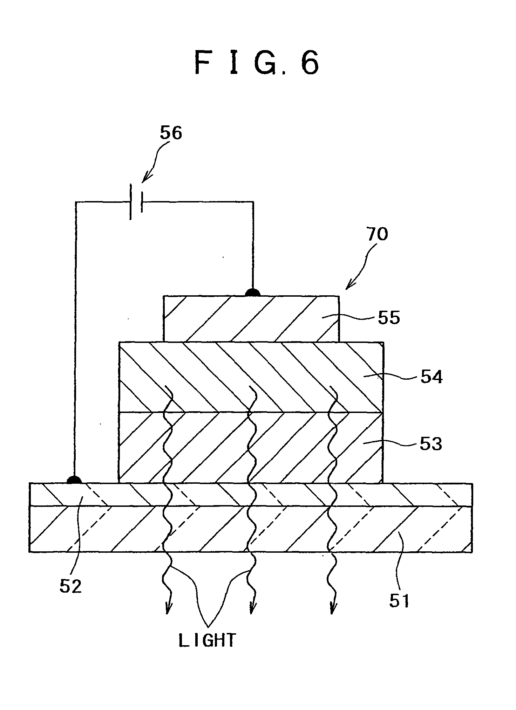

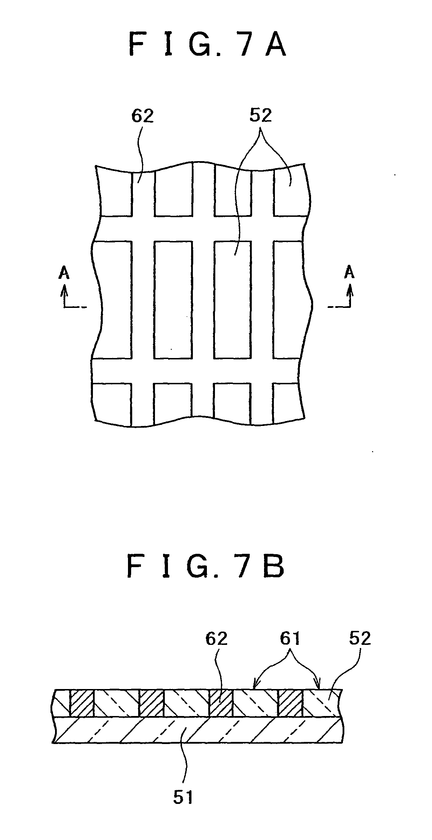

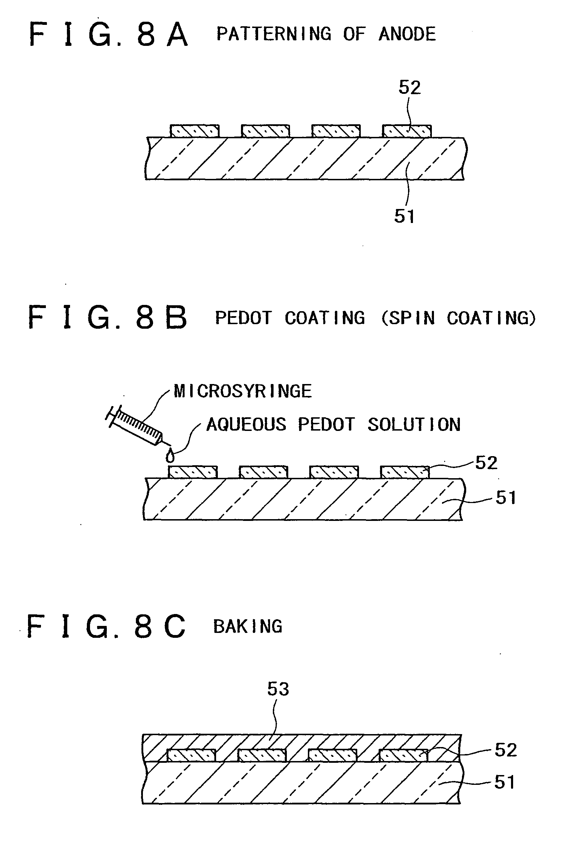

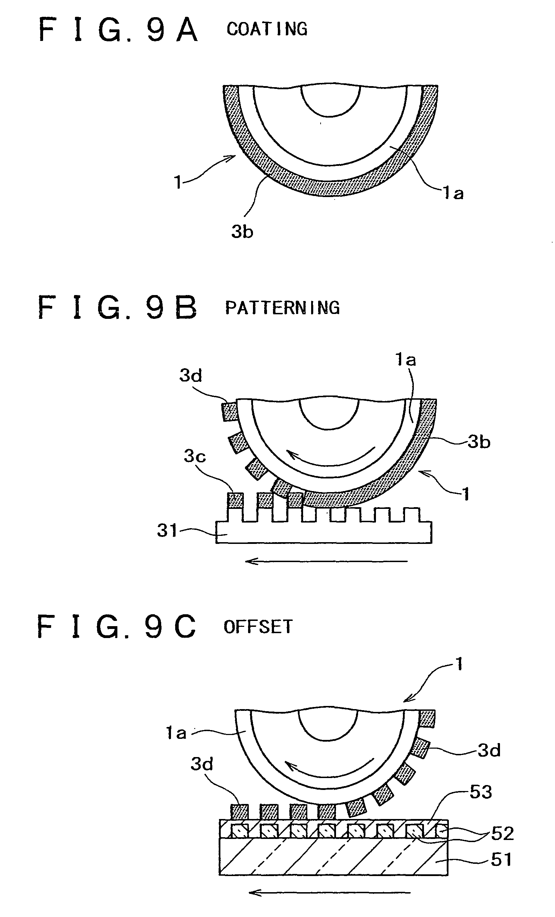

FIG. 6 is a general sectional view showing one example of an organic electroluminescence device obtained by the manufacturing method according to this embodiment (or a second embodiment which will be described later); FIGS. 7A and 7B pertain to the organic electroluminescence device of FIG. 6 in which FIG. 7A is a plan view of one example of a pattern of pixel electrode portions, and FIG. 7B is a sectional view taken along line A-A thereof; FIGS. 8A, 8B, and 8C pertain to a process of manufacturing the organic electroluminescence device of FIG. 6 and are sectional views for illustrating the steps of forming an anode on a glass substrate and a hole transport layer on the anode in a laminated form; and FIGS. 9A, 9B, and 9C pertain to the process of manufacturing the organic electroluminescence device of FIG. 6 and are sectional views for illustrating the steps (relief reversal offset printing step) of forming an electron-transporting light emission layer in a predetermined pattern on the hole transport layer on the glass substrate of FIG. 8C.

In the present invention, as a member (coating liquid drawing-up member) for coating the surface of a silicone blanket with a coating liquid containing a polymeric organic EL material, for example, a gravure roll 2 provided in its surface with a rugged pattern (a mesh, or a gravure pattern) and having a vertical sectional shape as shown in FIG. 3 is used. In the gravure roll, the rugged pattern is sufficiently moderate as compared with that of the above-mentioned wire bars 91, so that the uniformity of layer thickness of the coating film obtained is better as compared with that in the case of using the wire bars.

It should be noted, however, that even with the gravure roll 2 as shown in FIG. 3, if the gravure roll is a cylindrical one having a uniform diameter over its entire length, variations with time would be generated in the layer thickness, layer width, or the like of the coating liquid (contacted liquid portion) held between the roll surface and the silicone blanket surface, resulting in that the coating film formed on the silicone blanket would be in a stripe pattern as shown in FIG. 4. In the stripe pattern, coating film portions greater in film thickness and coating film portions smaller in film thickness are alternately formed in the shape of belts.

On the contrary, with a gravure roll 2 tapered at both end portions thereof as shown in FIG. 2B, the uniformity of layer thickness of the coating film is markedly enhanced and even an extremely thin coating film can be easily formed in a uniform layer thickness, which has been confirmed experimentally. Thus, for the manufacture of an organic electroluminescence device, cylindrical gravure rolls are preferred to wire bars, and, among the gravure rolls, the tapered gravure roll 2 shown in FIG. 2B is particularly preferable.

The gravure roll 2 has both its end portions so tapered that the diameter is decreased toward the outer side in the longitudinal direction, and its cylindrical portion 2a, which is a portion corresponding to an effective pixel forming portion of the silicone blanket 1, is provided in its surface with a smooth and gradual gravure pattern as shown in FIG. 3. In FIG. 2B, symbols 2b and 2c denote the tapered portions, which correspond to non-pixel-forming areas of the silicone blanket 1. In addition, the whole length of the gravure roll 2 is set to be equal to or slightly smaller than the whole length of the silicone blanket 1.

The method of manufacturing an organic electroluminescence device according to this embodiment is for manufacturing the so-called two-layer type organic ELD shown in FIG. 6, for example. Specifically, in forming an electron-transporting light emission layer 54 on a hole transport layer 53 in a transparent glass substrate 51 shown in FIG. 8C, a coating film composed of a coating liquid 3 containing a material for constituting the light emission layer (a solution or dispersion of the constituent material) is formed on the surface of the silicone blanket 1 by use of the gravure roll 2 (made of stainless steel, for example) as shown in FIGS. 1 and 2. In this case, a lower half of the gravure roll 2 is immersed in the coating liquid 3, and the silicone blanket 1 and the gravure roll 2 are rotated in counter directions (reverse roll system), whereby the coating liquid 3 is supplied and applied to the surface of the silicone blanket 1 from the lower side thereof via the gravure roll 2.

Next, with the silicone blanket 1 being rotated, the coating film is pressed against a relief printing plate provided with a predetermined pattern, whereby the coating film in the press contact areas is transferred and removed from the silicone blanket onto the relief printing plate. Then, the silicone blanket 1 is brought into contact with and rolled on the hole transport layer 53, whereby the pattern composed of the coating film left on the surface of the silicone blanket 1 is transferred onto the hole transport layer 53.

The silicone blanket 1 has a structure in which a silicone resin film 1a rich in coating film release property is formed on the surface of a cylindrical body, and the cylindrical body is set rotatable about a horizontal rotational axis. Therefore, the surface of the silicone blanket 1 is formed of the silicone resin. Besides, in this method of manufacturing an organic electroluminescence device, the gravure roll 2 tapered at both end portions thereof as shown in FIG. 2B is so disposed that the tapered portions are located beneath the non-pixel-forming areas present on both sides of the effective pixel forming area (mesh area, or gravure pattern forming area) of the silicone blanket 1. With this arrangement, the coating liquid is supplied and applied to the surface of the silicone blanket 1 from the lower side thereof while the layer width (the dimension in the vertical direction in FIG. 2B) of the coating liquid (contacted liquid portion) 3a held between the effective pixel forming area and the surface of the gravure roll 2 is kept uniform along the direction of the rotational axis of the silicone blanket 1. As a result, as shown in FIG. 5, the nonuniformity of layer width of the contacted liquid portion 3a is absorbed by the portions corresponding to the non-pixel-forming areas, and the coating film on the surface of the silicone blanket 1 is so formed that the layer thickness thereof in the effective pixel area is uniform and extremely small.

Now, the structure of the organic electroluminescence device shown in FIG. 6 will be described. In this organic electroluminescence device 70, the hole transport layer 53 is formed on the transparent glass substrate 51 provided with an ITO transparent pixel electrode (anode) 52, and an electron-transporting light emission layer 54 serving also as an electron transport layer is formed thereon. Further, a cathode 55 composed of a calcium (Ca) layer for enhancing electron injection property and an aluminum (Al) layer is provided on the electron-transporting light emission layer 54. Symbol 56 in FIG. 6 denotes a DC power source.

The ITO transparent pixel electrode 52 may be formed in island-like independent patterns for constituting pixel portions 61 as shown in FIG. 7A or may be formed in patterns which are isolated (insulated) from each other by an insulating material 62 as shown in FIG. 7B. Furthermore, the pixel electrode may be formed in stripes.

Next, one example of the process of manufacturing the organic electroluminescence device 70 will be described in more detail, referring to FIGS. 8A to 8C and 9A to 9C.

### (1) First Step

The ITO transparent pixel electrodes 52 are formed on the transparent glass substrate 51 by vacuum deposition and patterning (FIG. 8A).

### (2) Second Step

A liquid containing a hole transport layer forming material (for example, an aqueous solution of PEDOT) is supplied dropwise onto the ITO electrodes 52 by use of a microsyringe (FIG. 8B), and the transparent glass substrate 51 is rotated at high speed, whereby the ITO electrodes 52 are covered with the coating liquid (spin coating). Incidentally, the PEDOT will be described later.

### (3) Third Step

The coating liquid is baked to form the hole transport layer 53 (FIG. 8C).

Next, the following fourth to sixth steps (relief reversal offset printing step) are conducted to thereby form the electron-transporting light emission layer 54 on the hole transport layer 53, and then the subsequent seventh and eighth steps are conducted to thereby complete the organic electroluminescence device 70.

### (4) Fourth Step (Coating)

By use of the wet-type coating apparatus shown in FIGS. 1 and 2, as shown in FIG. 9A, a coating liquid containing a material for forming the electron-transporting light emission layer, for example, an organic solvent solution of poly(2-methoxy-5-(2'-ethylhexyloxy]-1,4-phenylenevinylene) (hereinafter abridged to MEH-PPV) is applied to the surface of the silicone blanket 1 in a predetermined layer thickness, to form a coating film 3b.

### (5) Fifth Step (Patterning)

As shown in FIG. 9B, the silicone blanket 1 is brought into contact with and rolled on a glass relief printing plate (glass mask) 31, whereby the coating film 3b in contact with the tips of relief portions of the glass relief printing plate 31 is transferred and removed from the surface of the silicone blanket 1. This leaves a desired coating film pattern 3d (effective pixel areas) on the silicone blanket 1. In FIG. 9B, symbol 3c denotes unrequired portions of the coating liquid. The relief portions of the relief printing plate 31 are preliminarily processed in a pattern reverse to the pattern of the electron-transporting light emission layer to be formed. In addition, since the surface of the silicone blanket 1 is formed of a silicone resin rich in liquid film release property, the transferring and removing step can be carried out easily and with high accuracy.

### (6) Sixth Step (Offset)

As shown in FIG. 9C, the silicone blanket 1 after the fifth step is brought into contact with and rolled on the glass substrate provided thereon with the hole transport layer, whereby the coating film pattern 3d left on the silicone blanket 1 is transferred onto the hole transport layer 53. Thereafter, the transferred pattern is baked and dried. By these steps, the electron-transporting light emission layer 54 is formed. The electron-transporting light emission layer 54 can be formed not only as a monochromic pattern but also as a pattern for full-color mode (for red color, for green color, or for blue color) by sequentially carrying out the relief reversal offset printing method.

### (7) Seventh Step

By vapor deposition and patterning, a calcium layer (not shown) is formed on the electron-transporting light emission layer 54 and an aluminum layer (not shown) as a main electrode is formed thereon, in respective predetermined layer thicknesses, and an Au-Ge layer (not shown) for protection and for enhancing a bonding property is formed on the aluminum layer in a predetermined layer thickness, to form a cathode 55.

### (8) Eighth Step

A counter substrate (not shown) is put on the Au-Ge layer, and side portions of the resultant assembly are sealed with an epoxy resin or the like, to complete the organic electroluminescence device 70.

### Second Embodiment

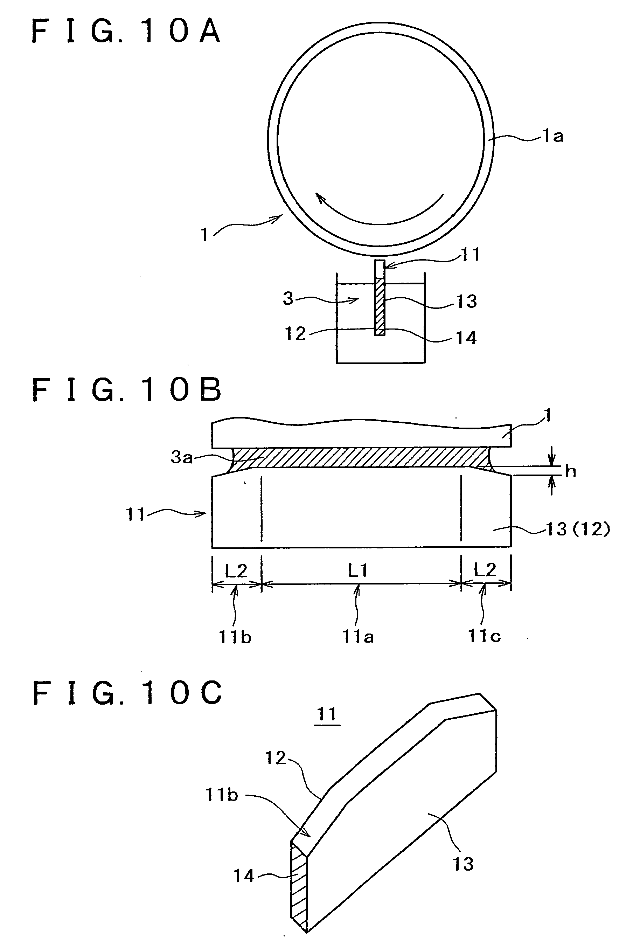

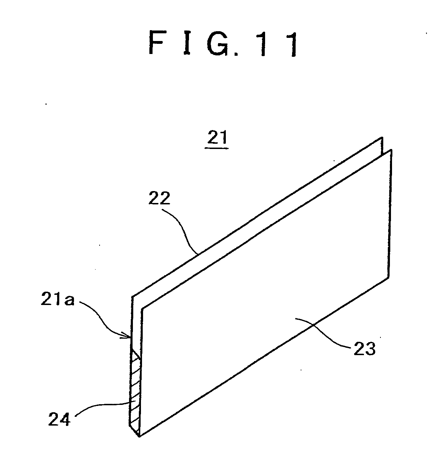

FIGS. 10A, 10B, and 10C pertain to a wet-type coating apparatus for use in the method of manufacturing an organic electroluminescence device (the relief reversal offset printing method) in which FIG. 10A is a front view of the wet-type coating apparatus for use in the method of manufacturing an organic electroluminescence device, FIG. 10B is a right side view showing an essential structure thereof, and FIG. 10C is a perspective view of a slit constituting the wet-type coating apparatus. FIG. 11 is a perspective view showing another example of the slit.

The method of manufacturing an organic electroluminescence device according to this embodiment is for manufacturing a two-layer type organic EL device shown in FIG. 6, for example, like in the first embodiment above. Specifically, in a glass substrate 51 shown in FIG. 8C, in forming an electron-transporting light emission layer 54 on a hole transport layer 53, a coating film composed of a coating liquid (a solution or a dispersion) containing a material for constituting the light emission layer is formed on the surface of a silicone blanket 1 by supplying and applying the coating liquid to the surface of the silicone blanket 1 from the lower side thereof via a slit 11 as a coating member (coating liquid drawing-up member), which is provided in parallel to the rotational axis of the silicone blanket 1, as shown in FIGS. 10A to 10C. The other steps are the same as those in the first embodiment above.

The slit 11 is constituted by disposing two stainless steel-made or glass-made flat plates 12 and 13 in parallel to and opposite to each other, with an appropriate spacing therebetween, in such a manner that the gaps between left and right end portions of the flat plates are entirely closed with flat plates 14 formed of the same material as that of the above flat plates 12 and 13. In this case, the spacing between the surface of the silicone blanket 1 and top faces of the two flat plates 12 and 13 is uniform at a slit portion corresponding to the effective pixel forming area of the silicone blanket 1. In addition, at slit portions corresponding to the non-pixel-forming areas present on both side of the effective pixel forming area of the silicone blanket 1, the top faces of the flat plates 12 and 13 are slant surfaces with a downward gradient from the central portion side toward the end portion sides along the rotational axis of the silicone blanket 1. In FIGS. 10B and 10C, symbol 11a denotes a flat portion (the top faces of the flat plates 12 and 13 are flat), and symbols 11b and 11c denote gradient portions constituted of the slant surfaces. The gradient portions correspond to the tapered portions 2b and 2c in the gravure roll shown in FIG. 2.

With such a slit 11 thus provided, the coating liquid is supplied and applied to the surface of the silicone blanket 1 from the lower side thereof via the slit 11 while the layer width of the coating liquid (contacted liquid portion) 3a held between the portion corresponding to the effective pixel forming area of the silicone blanket 1 and the top faces of the flat plates 12 and 13 is kept uniform along the direction of the rotational axis of the silicone blanket 1. According to this manufacturing method, like in the case of the first embodiment, the nonuniformity of layer width of the contacted liquid portion 3a in FIG. 10B is absorbed by the portions corresponding to the non-pixel-forming areas, resulting in that the coating film on the surface of the silicone blanket 1 is formed with the layer thickness in the effective pixel area uniform and extremely small, as shown in FIG. 5.

On the other hand, a slit 21 shown in FIG. 11 is formed by opposing two flat plates 22 and 23 to each other, with a spacing therebetween, opening upper half portions of gaps between left and right end portions of the flat plates 22 and 23 (open portions 21a), and closing lower half portions of the gaps with flat plates 24. In this case, the coating liquid is supplied and applied to the surface of the silicone blanket from the lower side thereof via the slit 21 while the layer width of the coating liquid (contacted liquid portion) held between the portion corresponding to the effective pixel forming area of the silicone blanket and top faces of the flat plates 22 and 23 is kept uniform along the direction of the rotational axis of the silicone blanket. In this slit 21, the open portions 21a correspond to the gradient portions 11b and 11c of the slit 11, and the same function and effect as those in the case of the slit 11 can be obtained.

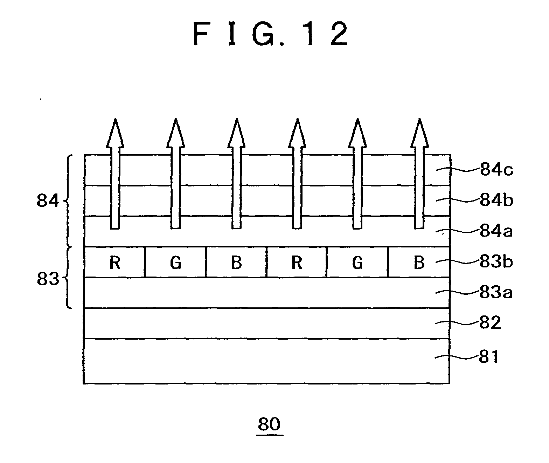

The manufacturing methods according to the first and second embodiments are preferable also for manufacturing a top emission type organic electroluminescence device 80 as shown in FIG. 12. The top emission type organic EL device 80 has a totally solid state structure in which a first electrode 82, an organic layer 83, and a second electrode 84 are sequentially laminated on a substrate 81, a passivation film (not shown) formed of a transparent dielectric material is laminated on the second electrode 84, and the passivation film is sealed (potted) with an epoxy resin and a glass, not shown. The substrate 81 is composed of, for example, a transparent glass substrate, a semiconductor substrate, or the like and may be a flexible one. The first electrode 82 is used as a cathode serving also as a reflective layer and is formed of a high reflective material, for example, chromium (Cr), silver (Ag), copper (Cu), gold (Au), platinum (Pt), tungsten (W), or an alloy thereof. The film thickness of the first electrode 82 is preferably set in the range of 100 to 300 nm.

The organic layer 83 is formed by forming a hole transport layer 83a by spin coating, drying it in vacuum at 120°C for one hour, and then forming a light emission layer 83b serving also as an electron transport layer by coating and drying. In forming the light emission layer 83b, printing is sequentially conducted for R, G, and B colors by the relief reversal printing method shown in FIG. 9, with each printing step followed by drying, for example, in vacuum at 120°C for one hour. The hole transport layer 83a is composed of the PEDOT described above. As a coating liquid for forming the light emission layer 83b, a solution prepared by dissolving a polymer organic EL material in an organic solvent is used.

As the polymeric organic EL material, the following materials are used correspondingly to R, G, and B colors, respectively.
For Red: poly[{9,9-dihexyl-2,7-bis(1-cyanovinylene)-fluorenylen}-alt-co-{2,5-bis(N,N'-diphenylamino)-1,4-phenylene}]
For Green: poly[{9,9-dioctylfluorenyl-2,7-diyl}-co-(1,4-diphenylene-vinylene-2-methoxy-5-{2-ethylhexyloxy}benzene)]
For Blue: poly[{9,9-dioctylfluorenyl-2,7-diyl5-co-{1,4-(2,5-dimethoxy)benzene}]

The layer thickness (film thickness) of the hole transport layer 83a and the light emission layer 83b is desirably set in the range of 15 to 100 nm. Here, the layer thickness of each of the organic layer 83 and component layers thereof is in terms of optical layer thickness. For example, where the PEDOT layer thickness is 20 nm, the Red layer thickness is 75 nm, the Green layer thickness is 65 nm, and the Blue layer thickness is 45 nm.

In addition, in the organic electroluminescence device 80, the second electrode 84 is composed of a Ca layer 84a formed by vapor deposition, an Mg-Ag layer 84b formed by vapor co-deposition, and an ITO layer 84c. Namely, the second electrode 84 has a layer constitution of vapor deposited Ca layer/vapor co-deposited Mg-Ag layer/ITO layer. The total layer thickness of the Ca layer 84a and the Mg-Ag layer 84b is set in the range of 5 to 50 nm, and the layer thickness of the Ca layer 84a is set in the range of 3 to 30 nm. The layer thickness of the ITO layer 84c is preferably set in the range of 30 to 1000 nm. Besides, in place of the ITO layer 84c, a layer of a material generally used as a transparent electrode, such as a mixture of indium and zinc oxide, may be formed. Furthermore, a passivation film (not shown) formed of a transparent dielectric material is laminated on the second electrode 84. As the transparent dielectric material, a material having a refractive index on the same level as that of the second electrode 84, for example, silicon oxide (SiO₂), silicon nitride (SiN), and the like can be used, and the layer thickness thereof is set, for example, in the range of 500 to 1000 nm.

The organic electroluminescence devices, which are the objects of the manufacturing method according to the present invention, include both bottom emission type organic electroluminescence devices shown in FIG. 6 and top emission type organic electroluminescence devices shown in FIG. 12. In addition, the light emission region layer includes not only those of the two-layer type shown in FIG. 6 but also those of the so-called three-layer type and five-layer type. A three-layer type organic electroluminescence device has a structure in which an ITO anode, a hole transport layer, a light emission layer, an electron transport layer, and a metallic cathode are laminated in this order on a glass substrate. On the other hand, a five-layer type organic electroluminescence device has a structure in which an ITO anode, a hole injection layer, a hole transport layer, a light emission layer, an electron transport layer, an electron injection layer, and a metallic cathode are laminated in this order on a glass substrate.

Now, examples of the present invention will be described.

### Example 1

### <Manufacture of Organic Electroluminescence Device>

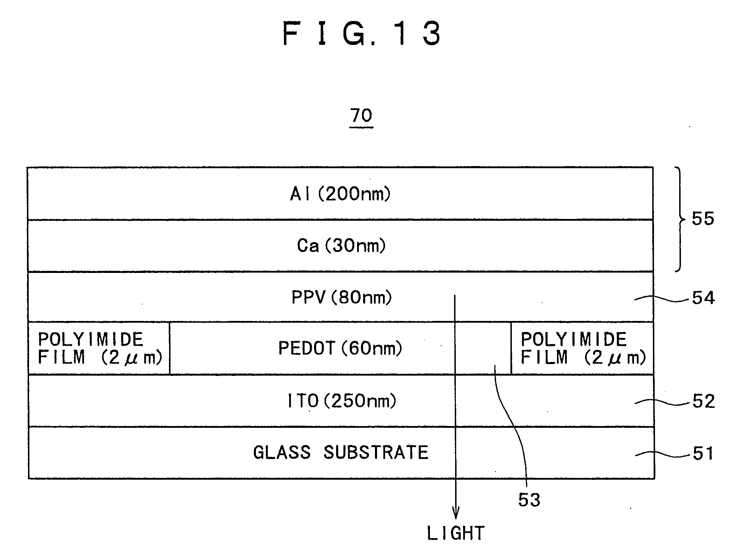

In this example, a bottom emission type polymeric organic electroluminescence device having laminate structure shown in FIGS. 6 and 13 was manufactured. Here, FIG. 13 illustrates the case where PPV was used as an electron-transporting polymer for forming an electron-transporting light emission layer; in this example, an EL light emission device using MEH-PPV in place of PPV and an EL light emission device using CN-PPV in place of PPV were manufactured. Incidentally, in FIG. 13, the polyimide film having a film thickness of 2 *µ* m is an insulation film.

First, a pattern of ITO transparent pixel electrode as the first electrode was formed in a film thickness of 250 nm on a square glass substrate having a side length of 30 mm. Next, an aqueous PEDOT solution for forming a hole transport layer was applied to the whole surface of the glass substrate by spin coating, to form a coating film having a layer thickness of 60 nm, thereby covering the ITO electrode. The coating film was baked in a nitrogen gas atmosphere at 120°C for one hour, to form the hole transport layer (for these steps, see FIG. 8). Here, PEDOT [poly(3,4)-ehtylenedioxythiophene] is a hole-transporting organic polymeric compound having a structural formula I:

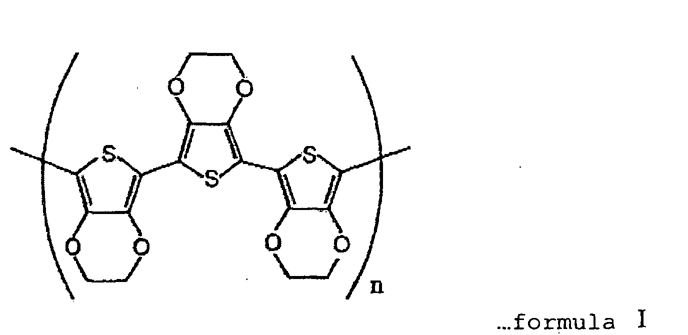

Next, by use of the wet-type coating apparatus shown in FIGS. 1 and 2, an electron-transporting light emission layer was formed by the relief reversal offset printing method shown in FIG. 9. The gravure roll shown in FIG. 2 is made of stainless steel, is tapered at both end portions thereof with its diameter gradually reduced toward the outer sides along its longitudinal direction, and its portion (cylindrical portion) corresponding to the effective pixel forming area of the silicone blanket was provided in its surface with a smooth and gradual gravure pattern as shown in FIG. 3. In this gravure roll, referring to FIG. 2B, the whole length (La+2Lb) was 80.0 mm, the length La of the cylindrical portion 2a was 60.0 mm, the length Lb of each of the tapered portions 2b and 2c was 10.0 mm, the diameter D of the cylindrical portion 2a was 12.0 mm, and the diameter d of the roll end portions was 11.6 mm. Besides, referring to FIG. 3, the depth of the valleys was 10 *µ*m, and the pitch of the valleys was 10 *µ*m. Incidentally, the whole length of the gravure roll was set equal to the whole length of the silicone blanket.

Thus, in the wet-type coating apparatus, in order to restrain the nonuniformity of layer thickness of the coating film, the length of the contacted liquid portion was controlled so as not to exceed the whole length of the gravure roll, the surface velocity of the silicone blanket was controlled to 3.0 mm/sec, and the surface velocity of the gravure roll was controlled to 2.0 mm/sec.

In the step of forming the electron-transporting light emission layer, an organic solvent solution 1, 2, or 3 of an electron-transporting polymer shown in the following (A), (B), or (C) was applied in a predetermined pattern, and the resulting coating film was baked in a nitrogen atmosphere at 70°C for two hour. After the baking, the layer thickness was 80±3 nm.

The components and compositions of the organic solvent solutions 1 to 3 of the electron-transporting polymers are as follows:
(A) Organic solvent solution 1
   - MEH-PPV of structural formula II 1.5 parts by weight
   - Mesitylene 39.0 parts by weight
   - Tetralin 60.0 parts by weight
(B) Organic solvent solution 2
   - PPV of structural formula III 1.5 parts by weight
   - Mesitylene 49.0 parts by weight
   - Tetralin 50.0 parts by weight
(C) Organic solvent solution 3
   - CN-PPV of structural formula IV 1.5 parts by weight
   - Mesitylene 44.0 parts by weight
   - Tetralin 55.0 parts by weight

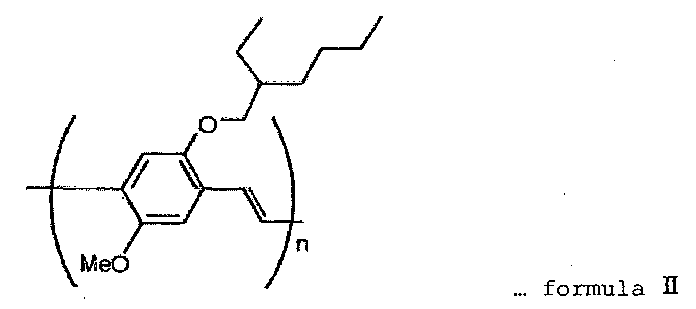

MEH-PPV: poly(2-methoxy-5-(2'-ethylhexyloxy)-1,4-phenylene-vinylene)

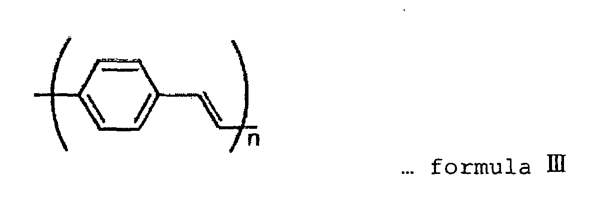

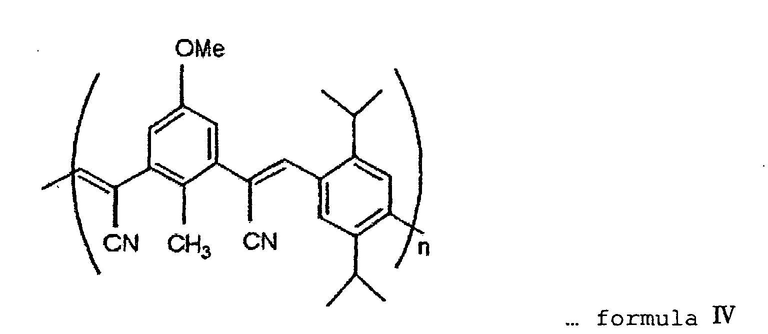

Incidentally, MEH-PPV has an emission color of orange and a fluorescence wavelength of 500 nm, PPV has an emission color of green and a fluorescence wavelength of 525 nm, and CN-PPV has an emission color of blue and a fluorescence wavelength of 430 nm.

Next, a calcium layer in a thickness of 30 nm and an aluminum layer (main electrode) in a thickness of 200 nm were sequentially formed on the electron-transporting light emission layer by vapor deposition, followed by patterning. Further, an Au-Ge layer for protection and for enhancing bonding property was formed on the aluminum layer, to form the second electrode.

### <Evaluation of Emission Characteristics of Organic Electroluminescence Device>

For the three kinds of organic electroluminescence devices manufactured as described above, emission efficiency and emission intensity were measured, the results being given below. From the results it was confirmed that, according to the relief reversal offset printing method using the wet-type coating apparatus according to the present invention, excellent light emission characteristics as those of an organic electroluminescence device with an electron-transporting light emission layer formed by the spin coating method according to the related art can be obtained.
(a) Orange light-emitting organic electroluminescence device (MEH-PPV was used)

| | |
|---|---|
| Emission efficiency | 2.2 cd/A |
| Emission intensity | 1200 cd/m² |

(b) Green light-emitting organic electroluminescence device (PPV was used)

| | |
|---|---|
| Emission efficiency | 2.4 cd/A |
| Emission intensity | 1500 cd/m² |

(c) Blue light-emitting organic electroluminescence device (CN-PPV was used)

| | |
|---|---|
| Emission efficiency | 1.4 cd/A |
| Emission intensity | 1000 cd/m² |

### Example 2

### <Manufacture of Organic Electroluminescence Device>

An orange light-emitting organic electroluminescence device, a green light-emitting organic electroluminescence device, and a blue light-emitting organic electroluminescence device were manufactured by use of the same apparatus, method, and conditions as in Example 1, except that the apparatus shown in FIG. 10 was used as the wet-type coating apparatus for forming an electron-transporting light emission layer. In these cases, referring to FIG. 10B, the whole length (L₁+2L₂) of the slit was 80.0 mm, the length L₁ of the flat portion 11a was 60.0 mm, the length L₂ of each of the gradient portions 11b and 11c was 10.0 mm, and the gradient (h/L₂) thereof was 1/50. In addition, the slit spacing (the spacing between the opposed flat plates 12 and 13) was set to 200 *µ*m, and the whole length of the slit was set equal to the whole length of the silicone blanket. Thus, the length of the contacted liquid portion was controlled so as not to exceed the whole length of the slit, and the surface velocity of the silicone blanket was controlled to 3.0 mm/sec. The organic electroluminescence devices thus obtained had emission efficiency and emission intensity characteristics equivalent to those obtained in Example 1.

While a preferred embodiment of the invention has been described using specific terms, such description is for illustrative purposes only, and it is to be understood that changes and variations may be made without departing from the spirit or scope of the following claims.

## Claims

1. A method of manufacturing an organic electroluminescence device comprising, between a first electrode and a second electrode, layers having light emission regions patterned on a pixel basis, wherein
at least one of said layers having said light emission regions is formed by
forming a coating film comprised of a coating liquid containing a constituent material of said layer on a surface of a silicone blanket, then pressing a relief printing plate against said coating film, transferring and removing said coating film at the pressed areas from said silicon blanket onto said relief printing plate, and transferring a pattern composed of said coating film left on said surface of said silicone blanket onto a surface to be provided thereon with said layer, and
said coating liquid is supplied and applied to said surface of said silicone blanket from the lower side thereof via a gravure roll provided with a gravure pattern.

2. The method of manufacturing an organic electroluminescence device as set forth in claim 1, wherein
said gravure roll, which is tapered at both end portions thereof, is provided in such a position that said tapered portions correspond to non-pixel-forming areas on both sides of an effective pixel forming area, of said silicone blanket, and
said coating liquid is supplied and applied to said surface of said silicone blanket from the lower side thereof.

3. A method of manufacturing an organic electroluminescence device comprising, between a first electrode and a second electrode, layers having light emission regions patterned on a pixel basis, wherein
at least one of said layers having said light emission regions is formed by
forming a coating film comprised of a coating liquid containing a constituent material of said layer on a surface of a silicone blanket, then pressing a relief printing plate against said coating film, transferring and removing said coating film at the pressed portions from said silicone blanket onto said relief printing plate, and transferring a pattern composed of said coating film left on said surface of said silicone blanket onto a surface to be provided thereon with said layer, and
said coating liquid is supplied and applied to said surface of said silicone blanket from the lower side thereof via a slit provided in parallel to the rotational axis of said silicone blanket.

4. The method of manufacturing an organic electroluminescence device as set forth in claim 3, wherein
said slit is formed by opposing two flat plates to each other with a spacing therebetween, and totally closing gaps between left and right end portions of said flat plates,
the spacing between said surface of said silicone blanket and top faces of said two flat plates is uniform at a slit portion corresponding to an effective pixel forming area of said silicone blanket, whereas said top faces of said two flat plates are slant surfaces with a downward gradient from the central portion side toward end portion sides of the rotational axis of said silicone blanket at slit portions corresponding to non-pixel-forming areas present on both sides of said effective pixel forming area of said silicone blanket, and
said coating liquid is supplied and applied to said surface of said silicone blanket from the lower side thereof via said slit.

5. The method of manufacturing an organic electroluminescence device as set forth in claim 3, wherein
said slit is formed by opposing two flat plates to each other with a spacing therebetween, opening upper half portions of gaps between left and right end portions of said flat plates, and closing lower half portions of said gaps, and
said coating liquid is supplied and applied to said surface of said silicone blanket from the lower side thereof via said slit.
